# EUROPEAN PATENT SPECIFICATION

(11) **EP 3 553 815 B1**
(45) Date of publication and mention of the grant of the patent: **29.04.2026**
(21) Application number: 18213006.2
(22) Date of filing: 17.12.2018
(51) Int. Cl.: H10D 30/62, H10W 10/00, H10W 10/17, H10B 12/00

(54) **SEMICONDUCTOR DEVICE AND METHOD FOR MANUFACTURING THE SAME**
HALBLEITERBAUELEMENT UND VERFAHREN ZUR HERSTELLUNG DAVON
DISPOSITIF SEMICONDUCTEUR ET SON PROCÉDÉ DE FABRICATION

(30) Priority: 20.03.2018 KR 20180032063; 29.06.2018 US 201816023018
(43) Date of publication of application: 16.10.2019
(73) Proprietor: Samsung Electronics Co., Ltd., Suwon-si, Gyeonggi-do, 16677 (KR)
(72) Inventor: YOON, Sungmi, 05512 Seoul (KR); CHUNG, Chunhyung, 05502 Seoul (KR)
(74) Representative: Kuhnen & Wacker Patent- und Rechtsanwaltsbüro PartG mbB

(56) References cited:
- US-A1- 2006 003 546
- US-A1- 2007 020 855
- US-A1- 2010 117 048
- US-A1- 2012 164 842
- YAMAUCHI S ET AL: "200V Super Junction MOSFET Fabricated by High Aspect Ratio Trench Filling", PROCEEDINGS OF THE 18TH INTERNATIONAL SYMPOSIUM ON POWER SEMICONDUCTOR DEVICES & ICS; 4-8 JUNE 2006; NAPLES, ITALY. (IEEE CAT. NO. 06CH37817C), IEEE OPERATIONS CENTER, PISCATAWAY, NJ, USA, 4 June 2006 (2006-06-04), pages 1 - 4, XP002620529, ISBN: 978-0-7803-9714-9, DOI: 10.1109/ISPSD.2006.1666072

## Description

### CROSS-REFERENCE TO THE RELATED APPLICATION

### BACKGROUND

### 1. Field

Methods and apparatuses consistent with the example embodiments of the inventive concepts relate to a semiconductor device, more particularly, to a semiconductor device including a data storage element and a method for manufacturing the same.

### 2. Description of the Related Art

Semiconductor devices are widely used in an electronic industry because of their small sizes, multi-functional characteristics, and/or low manufacture costs. Data storage devices among the semiconductor devices may store logical data. The data storage devices have been highly integrated with the development of the electronic industry. Thus, the size of elements or components of the data storage devices has been reduced.

In addition, high reliability of the data storage devices is required with the high integration of the data storage devices. However, the reliability of the data storage devices may be deteriorated by the high integration. Thus, various researches have been carried out to improve the reliability of the data storage devices.

A method of manufacturing a semiconductor device is known from US 2007/0020855 A1 in which a semiconductor substrate is patterned in order to form active patterns separated by trenches. A devices isolation layer is formed on the semiconductor substrate. The device isolation layer and the plurality of active patterns are patterned such that a second trench is formed intersecting the first trench. Also a gate electrode is formed.

US 2006/0003546 A1 teaches a two-form semiconductor layer on the substrate. The semiconductor layer is of equal thickness throughout its extension.

US 2012/0164842 A1 is directed to a trench embedding method including forming an oxidization barrier film on a trench and forming an expandable film on the oxidization barrier film.

### SUMMARY

The invention provides a method of manufacturing a semiconductor device according to claim 1.

### BRIEF DESCRIPTION OF THE DRAWINGS

The inventive concepts will become more apparent in view of the attached drawings and accompanying detailed description.
FIGs. 1, 3, 5, 7, 9, 11, 13 and 15 are plan views illustrating a method for manufacturing a semiconductor device according to example embodiments.
FIGs. 2A, 4A, 6A, 8A, 10A, 12A, 14A and 16A are cross-sectional views taken along lines A-A' of FIGs. 1, 3, 5, 7, 9, 11, 13 and 15, respectively.
FIGs. 2B, 4B, 6B, 8B, 10B, 12B, 14B and 16B are cross-sectional views taken along lines B-B' of FIGs. 1, 3, 5, 7, 9, 11, 13 and 15, respectively.
FIGs. 2C, 4C, 6C, 8C, 10C, 12C, 14C and 16C are cross-sectional views taken along lines C-C' of FIGs. 1, 3, 5, 7, 9, 11, 13 and 15, respectively.
FIGs. 17 and 18 are schematic cross-sectional views illustrating deposition apparatuses for forming a semiconductor laye ; figure 17 showing a batch-type reaction chamber not covered by the invention and figure 18 showing a single-type reaction chamber covered by the invention.
FIGs. 19A, 19B and 19C are cross-sectional views taken along the lines A-A', B-B' and C-C' of FIG. 5, respectively, to illustrate a method for manufacturing a semiconductor device according to example embodiments.
FIG. 20 is a cross-sectional view taken along the line B-B' of FIG. 15 to illustrate a semiconductor device according to example embodiments.
FIG. 21 is an enlarged cross-sectional view of a region 'M' of FIG. 20.

### DETAILED DESCRIPTION OF THE EXAMPLE EMBODIMENTS

Various example embodiments of the inventive concepts will be described more fully hereinafter with reference to the accompanying drawings. The inventive concepts may, however, be embodied in many different forms and should not be construed as limited to the embodiments set forth herein. Rather, these embodiments are provided so that this description will be thorough and complete, and will fully convey the scope of the inventive concepts to those skilled in the art. In the drawings, the sizes and relative sizes of layers and regions may be exaggerated for clarity.

It will be understood that when an element or layer is referred to as being "over," "above," "on," "connected to" or "coupled to" another element or layer, it can be directly over, above, on, connected or coupled to the other element or layer or intervening elements or layers may be present. In contrast, when an element is referred to as being "directly over," "directly above," "directly on," "directly connected to" or "directly coupled to" another element or layer, there are no intervening elements or layers present. Like numerals refer to like elements throughout. As used herein, the term "and/or" includes any and all combinations of one or more of the associated listed items.

The terms "first," "second," "third," etc. are used only to distinguish the different components or elements such as "trenches" or "directions" described herein, not being limited thereto, from one another. For example, "a third trench TR3" described in the embodiments could be termed "a second trench" in the claims of the present application when the claim needs to represent the third trench TR3 but the term "a second trench" has not been used in the claim after the term "a first trench." Likewise, "a second trench TR2" described in the embodiments could be termed "a third trench" in the claims when the term "a second trench" has already been used in the claims to indicate another trench. Likewise, "a second direction D2" described in the embodiments could be termed "a first direction" in the claims as necessary.

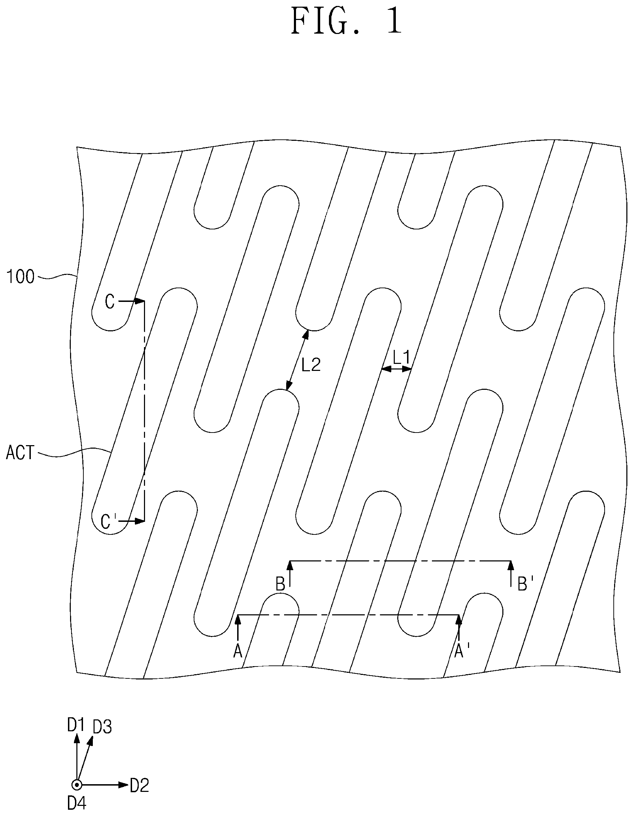

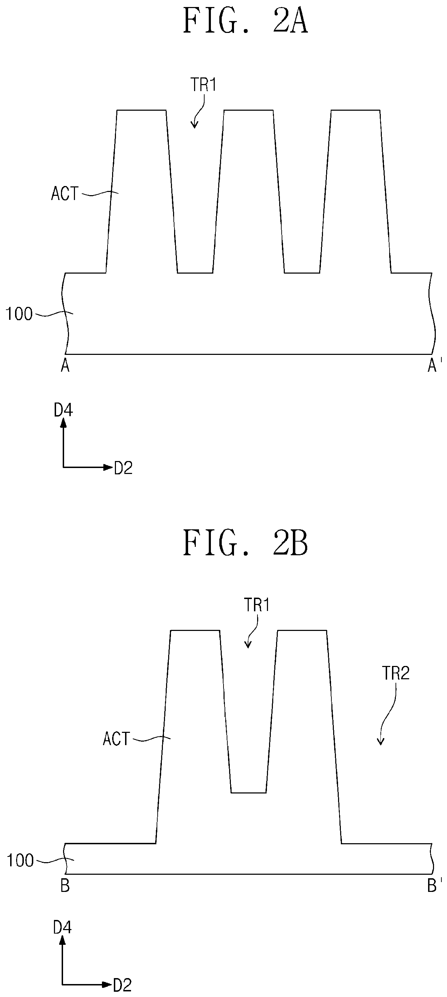

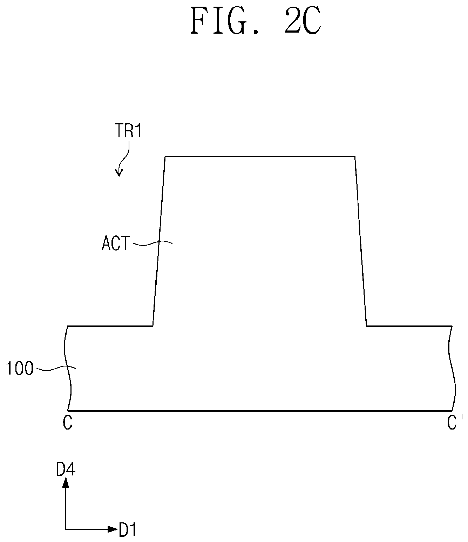

FIGs. 1, 3, 5, 7, 9, 11, 13 and 15 are plan views illustrating a method for manufacturing a semiconductor device according to example embodiments of the inventive concepts. FIGs. 2A, 4A, 6A, 8A, 10A, 12A, 14A and 16A are cross-sectional views taken along lines A-A' of FIGs. 1, 3, 5, 7, 9, 11, 13 and 15, respectively. FIGs. 2B, 4B, 6B, 8B, 10B, 12B, 14B and 16B are cross-sectional views taken along lines B-B' of FIGs. 1, 3, 5, 7, 9, 11, 13 and 15, respectively. FIGs. 2C, 4C, 6C, 8C, 10C, 12C, 14C and 16C are cross-sectional views taken along lines C-C' of FIGs. 1, 3, 5, 7, 9, 11, 13 and 15, respectively.

Referring to FIGs. 1 and 2A to 2C, an upper portion of a substrate 100 may be patterned to form active patterns ACT. For example, the substrate 100 may be a semiconductor substrate including silicon, germanium, or silicon-germanium. Each of the active patterns ACT may extend in a third direction D3 parallel to a top surface of the substrate 100 where the active patterns are not formed. Some of the active patterns ACT may be spaced apart from each other in the third direction D3. Each of the active patterns ACT may have a width which becomes progressively decreased in an upward direction (i.e., a fourth direction D4) from the top surface of the substrate 100 where the active patterns are not formed. The width of each of the active patterns ACT may decrease as a distance from a bottom surface of the substrate 100 increases.

First and second trenches TR1 and TR2 may be defined between the active patterns ACT. The first trench TR1 may be defined between two active patterns ACT adjacent to each other in a second direction D2. The second trench TR2 may be defined between two active patterns ACT adjacent to each other in the third direction D3.

A distance between the two active patterns ACT adjacent to each other in the second direction D2 may be a first distance L1. A distance between the two active patterns ACT adjacent to each other in the third direction D3 may be a second distance L2. The second distance L2 may be greater than the first distance L1. Thus, the second trench TR2 may be deeper than the first trench TR1 with respect to top surfaces of the active patterns ACT. In other words, a bottom of the second trench TR2 may be lower than a bottom of the first trench TR1.

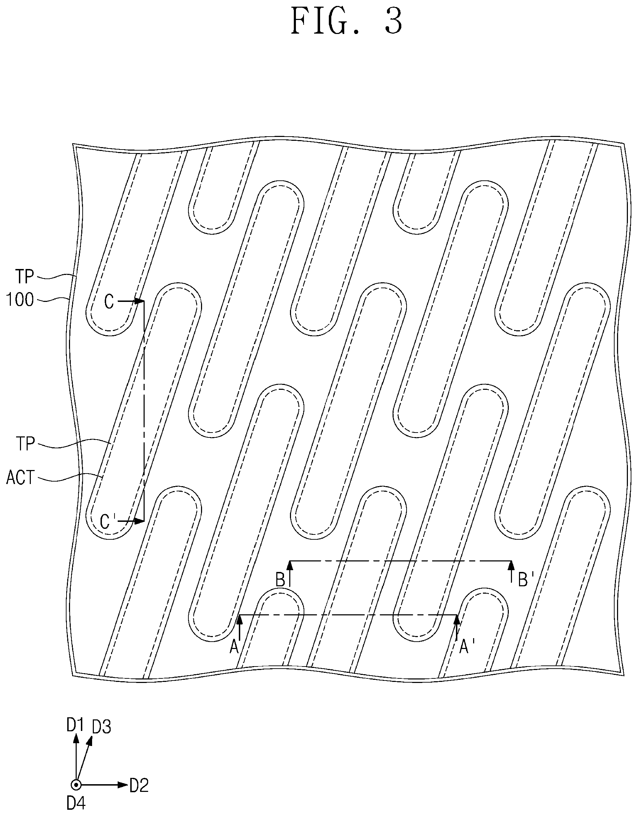

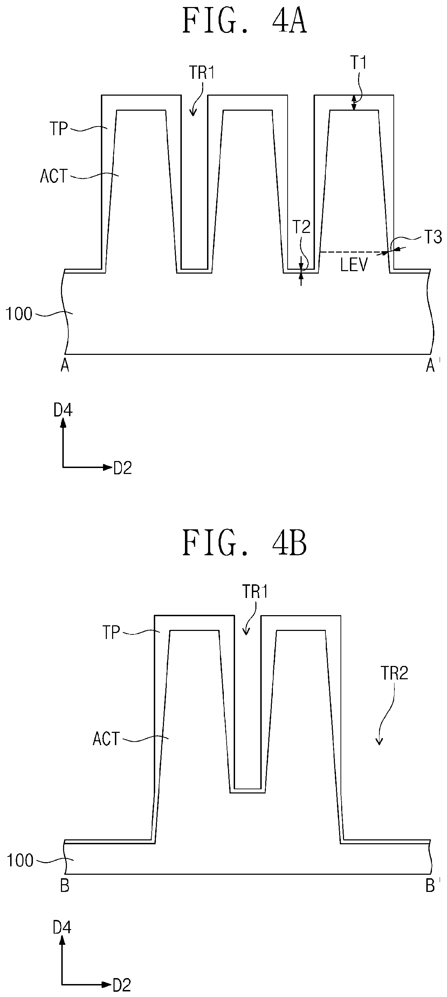

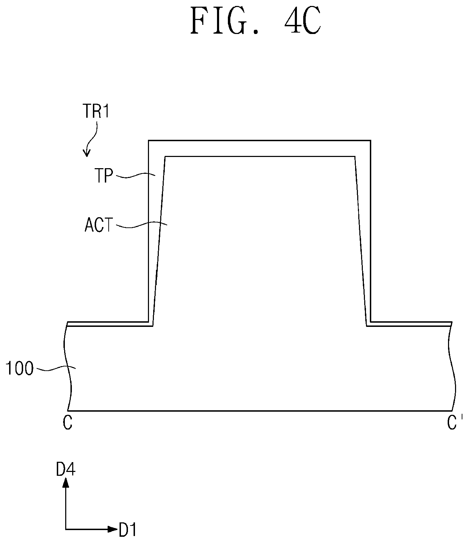

Referring to FIGs. 3 and 4A to 4C, a semiconductor layer TP may be formed on an entire surface of the substrate 100. According to the invention, the semiconductor layer TP is formed to cover the active patterns ACT. The semiconductor layer TP may be formed to partially fill the first and second trenches TR1 and TR2. The semiconductor layer TP may be formed using the same semiconductor material as the substrate 100. For example, the semiconductor layer TP may be a poly-silicon layer.

The semiconductor layer TP may be non-conformally formed. In other words, the semiconductor layer TP may be formed using a deposition condition (or recipe) having a low step coverage. According to the invention, the step coverage of the deposition process of the semiconductor layer TP ranges from 0.5 to 0.85.

In example embodiments, the step coverage may be a ratio of a second thickness T2 of the semiconductor layer TP on the bottom of the first trench TR1 to a first thickness T1 of the semiconductor layer TP on the top surface of the active pattern ACT.

In example embodiments, the step coverage may be a ratio of a third thickness T3 of the semiconductor layer TP on a sidewall of the active pattern ACT at one level LEV to the first thickness T1 of the semiconductor layer TP on the top surface of the active pattern ACT. The one level LEV may be a level at 1200Å below the top surface of the active pattern ACT. The second thickness T2 may be substantially equal to the third thickness T3.

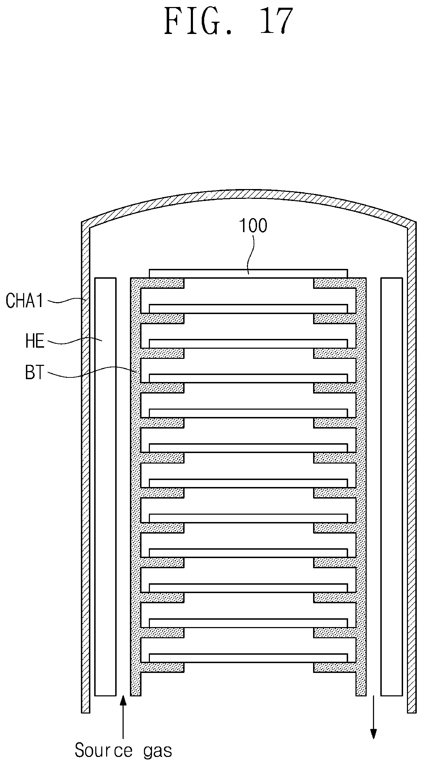

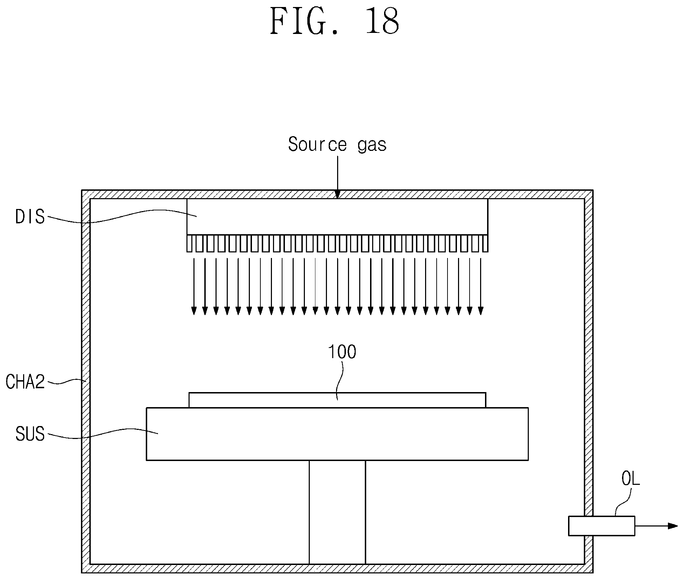

The semiconductor layer TP may be formed using a chemical vapor deposition (CVD) process. FIGs. 17 and 18 are schematic cross-sectional views illustrating deposition apparatuses for forming the semiconductor layer TP according to example embodiments.

A CVD process according to an example embodiment will be described with reference to FIGs. 3, 4A to 4C and 17. According to an example not forming part of the invention, a first reaction chamber CHA1 may be a batch-type chamber. The first reaction chamber CHA1 may have a hollow cylindrical shape. A boat BT may be loaded in the first reaction chamber CHA1. The boat BT may have a plurality of slots. The substrate 100 may be inserted in each of the slots. In other words, a plurality of substrates 100 may be disposed in the first reaction chamber CHA1 by the boat BT.

The CVD process may be performed to deposit the semiconductor layer TP on each of the substrates 100 inserted in each of the slots. The CVD process may be performed by injecting a source gas into an inlet of the first reaction chamber CHA1, and exhausting the source gas through an outlet of the first reaction chamber CHA1. A temperature of the CVD process may be controlled by a heater HE disposed in the first reaction chamber CHA1.

As described above, the CVD process according to the present embodiment may use the deposition process having the low step coverage. Reactivity of the CVD process may be improved to lower the step coverage. When the reactivity of the CVD process is improved, most of the source gas may react on an upper portion of the active pattern ACT and a small amount of the source gas may be provided into and react in lower regions of the first and second trenches TR1 and TR2. As a result, the first thickness T1 of the semiconductor layer TP on the top surface of the active pattern ACT may be greater than the second thickness T2 of the semiconductor layer TP on the bottom of the first trench TR1.

When the CVD process is performed using the first reaction chamber CHA1, the source gas of which reactivity is relatively great may be used to improve the reactivity of the CVD process. The reactivity of the source gas may increase as the number of silicon atoms in a molecule of the source gas (e.g., silane) increases. The source gas according to the present embodiment may include SiₓH₂ₓ₊₂. Here, 'x' may be an integral number equal to or greater than 3. For example, the source gas according to the present embodiment may include trisilane, tetrasilane or pentasilane.

The CVD process using the first reaction chamber CHA1 may be performed at a pressure of about 1×10⁻¹ Torr to about 1 Torr and a temperature of about 350°C to about 600°C. A flow rate of the source gas of the CVD process using the first reaction chamber CHA1 may range from about 100 sccm to about 400 sccm.

According to some comparative examples of the inventive concepts, the substrate 100 on which the active patterns ACT were formed was disposed in the first reaction chamber CHA1. A CVD process was performed using tetrasilane (Si₄H₁₀) as the source gas to form the semiconductor layer TP (Experimental Example 1). A pressure in the first reaction chamber CHA1 was 1×10⁻¹ Torr and a temperature in the first reaction chamber CHA1 was 400°C during the CVD process. The step coverage of the CVD process of the Experimental Example 1 was confirmed through measuring a thickness of the semiconductor layer TP.

According to some comparative examples of the inventive concepts, a CVD process was carried out under the same conditions as in the Experimental Example 1 except that disilane (Si₂H₆) was used as the source gas (Comparative Example 1). The step coverage of the CVD process of the Comparative Example 1 was confirmed through measuring a thickness of the semiconductor layer TP. The results are shown in Table 1 below.

**[Table 1]**

| | Experimental Example 1 (Si₄H₁₀) | Comparative Example 1 (Si₂H₆) |
|---|---|---|
| Step Coverage | 0.8 to 0.85 | 0.95 to 0.99 |

Referring to Table 1, the step coverage of the CVD process of the Experimental Example 1 was significantly lower than the step coverage of the Comparative Example 1. In other words, by controlling the number of silicon atoms in a molecule of the source gas, it is possible to realize a CVD process with the desired step coverage of the inventive concepts.

A CVD process according to an example embodiment of the inventive concepts will be described with reference to FIGs. 3, 4A to 4C and 18. According to the invention, the second reaction chamber CHA2 is a single-type chamber. A susceptor SUS may be disposed in the second reaction chamber CHA2. A single substrate 100 may be disposed on the susceptor SUS. The susceptor SUS may heat the substrate 100. A distribution plate DIS may be provided over the susceptor SUS in the second reaction chamber CHA2.

The CVD process may be performed to deposit the semiconductor layer TP on the substrate 100. The CVD process in the present embodiment may be performed by injecting a source gas into the distribution plate DIS of the second reaction chamber CHA2, and exhausting the source gas through an outlet of the second reaction chamber CHA2.

As described above, the CVD process according to the present embodiment may use the deposition process having the low step coverage. Reactivity of the CVD process may be improved to lower the step coverage. When the CVD process is performed using the second reaction chamber CHA2, a process condition of a relatively high pressure may be used to improve the reactivity of the CVD process.

In the first reaction chamber CHA1 described above with reference to FIG. 17, the CVD process should be uniformly performed on the plurality of substrates 100. Thus, the inside of the first reaction chamber CHA1 cannot be maintained at a high pressure. On the contrary, since the second reaction chamber CHA2 according to the present embodiment is the single-type chamber in which the single substrate 100 is loaded, the inside of the second reaction chamber CHA2 may be maintained at a high pressure. As a result, the pressure of the inside of the second reaction chamber CHA2 may be increased to improve the reactivity of the CVD process.

Acccording to the invention, the CVD process using the second reaction chamber CHA2 is performed at a high pressure of 10 Torr to 200 Torr and a temperature of 400°C to 600°C. A flow rate of the source gas of the CVD process using the second reaction chamber CHA2 ranges from 5 sccm to 50 sccm.

Since the reactivity of the CVD process using the second reaction chamber CHA2 is adjusted using the relatively high pressure, a kind of the source gas used in the CVD process may be various. For example, the source gas according to the present embodiment may include SiₓH₂ₓ₊₂, SiCl₄, SiCl₆, or SiCl₂H₄. Here, 'x' may be an integral number equal to or greater than 1. In example embodiments, the source gas may include monosilane or disilane.

Hydrogen may be additionally injected together with the source gas in the CVD process using the second reaction chamber CHA2. Since the hydrogen is additionally injected, the reactivity of the CVD process may be more improved.

In examples not forming part of the invention, even though not shown in the drawings, a semiconductor nitride layer may be formed to cover the active patterns ACT, and then, the semiconductor layer TP may be formed on the semiconductor nitride layer. The formation of the semiconductor nitride layer and the formation of the semiconductor layer TP may be sequentially performed in the first reaction chamber CHA1 of FIG. 17 or the second reaction chamber CHA2 of FIG. 18. The formation of the semiconductor nitride layer may use aminosilane as a source gas.

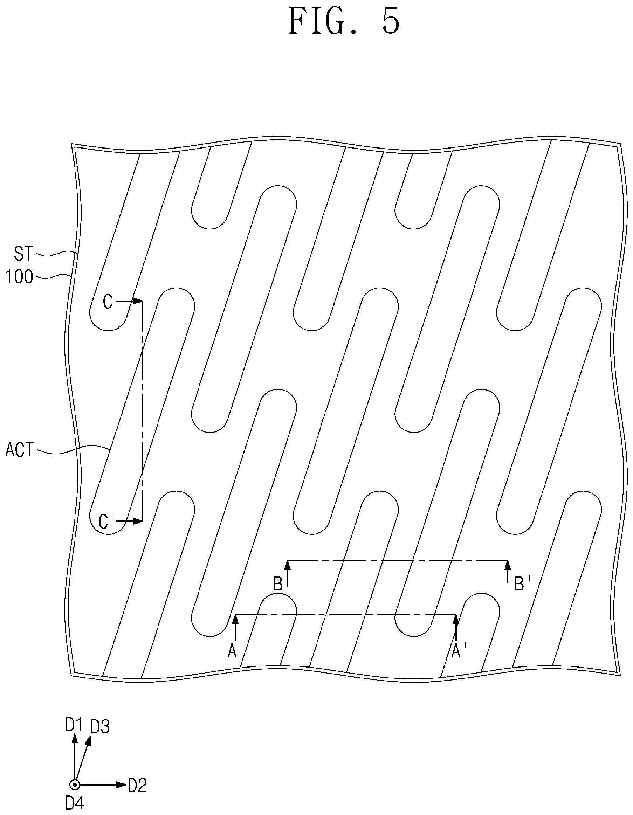

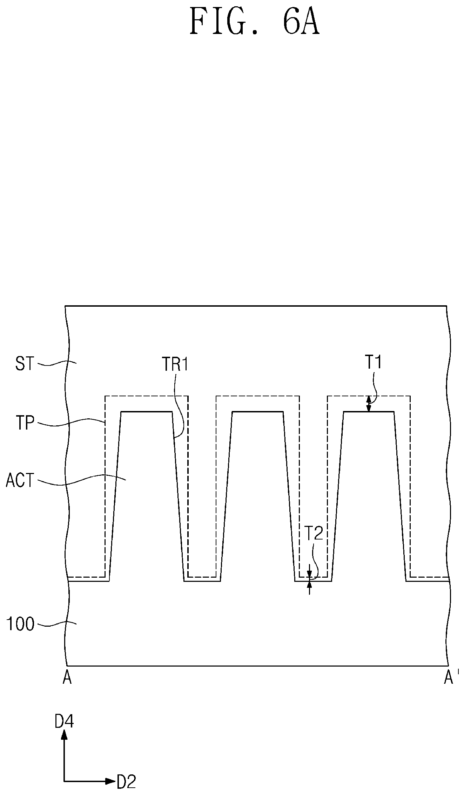

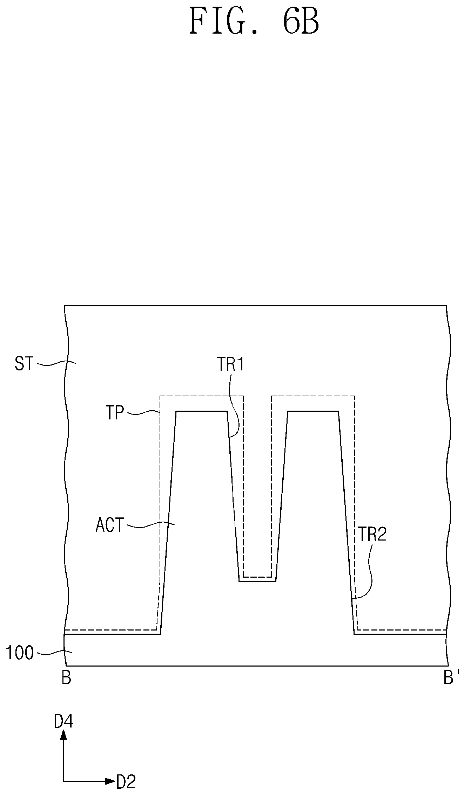

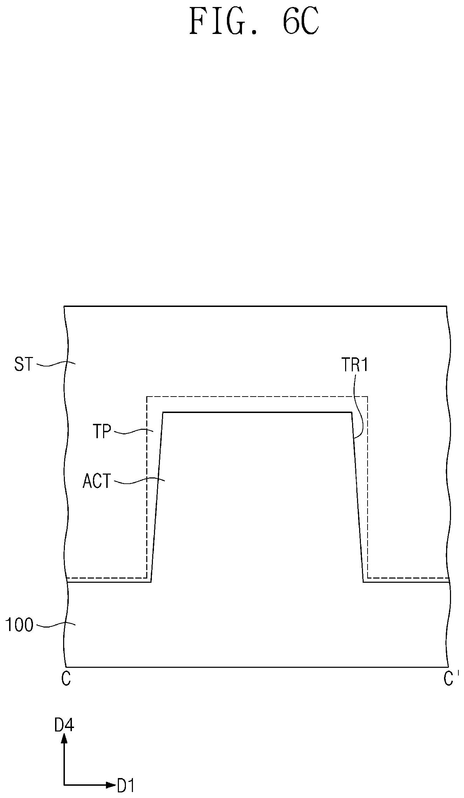

Referring to FIGs. 5 and 6A to 6C, a device isolation layer ST may be formed to fill the first and second trenches TR1 and TR2. The device isolation layer ST may completely fill the first and second trenches TR1 and TR2 and may cover the active patterns ACT and the semiconductor layer TP formed thereon. For example, the device isolation layer ST may include a silicon oxide layer.

The formation of the device isolation layer ST includes performing a semiconductor oxidation process. During the semiconductor oxidation process, the semiconductor layer TP is oxidized to form a semiconductor oxide layer (e.g., a silicon oxide layer). The semiconductor oxide layer may form at least a portion of the device isolation layer ST.

The amount of the semiconductor material oxidized by the semiconductor oxidation process may increase as a level in the fourth direction D4 increases (i.e., as a distance from the bottom surface of the substrate 100 increases). For example, the semiconductor material on the top surface of the active pattern ACT may be oxidized such that its thickness is reduced by the first thickness T1, and the semiconductor material on the bottom of the first trench TR1 may be oxidized such that its thickness is reduced by the second thickness T2. The first thickness T1 may be greater than the second thickness T2. This may be because oxidation reactivity of the semiconductor oxidation process increases as a distance from the bottom surface of the substrate 100 increases.

In consideration of the semiconductor oxidation process, the semiconductor layer TP described above with reference to FIGs. 3 and 4A to 4C may be formed in such a way that its thickness increases as a distance from the bottom surface of the substrate 100 increases. Thus, during the semiconductor oxidation process, the semiconductor layer TP may be selectively oxidized but the active patterns ACT may remain without being oxidized. In other words, during the semiconductor oxidation process, the semiconductor layer TP protects the active patterns ACT from being oxidized.

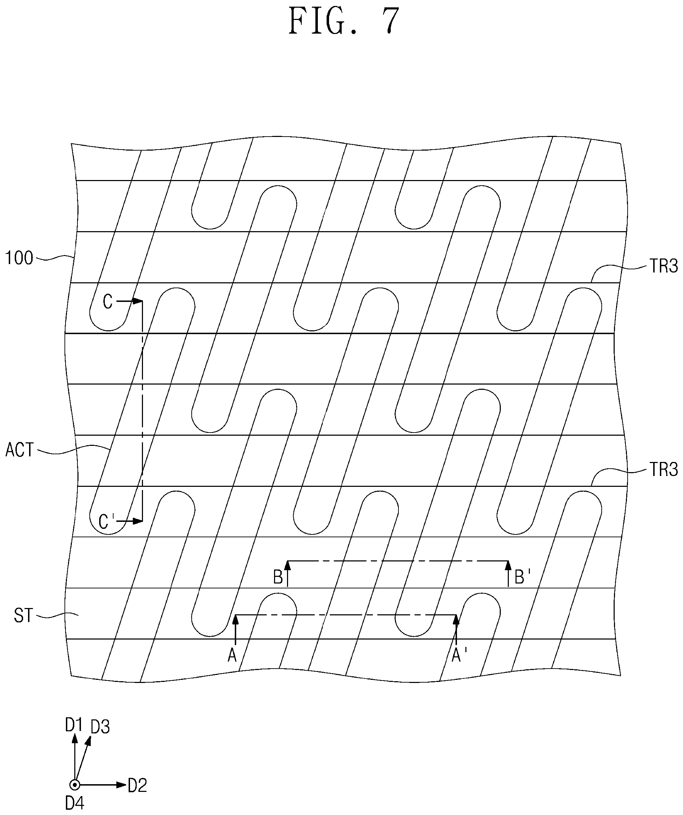

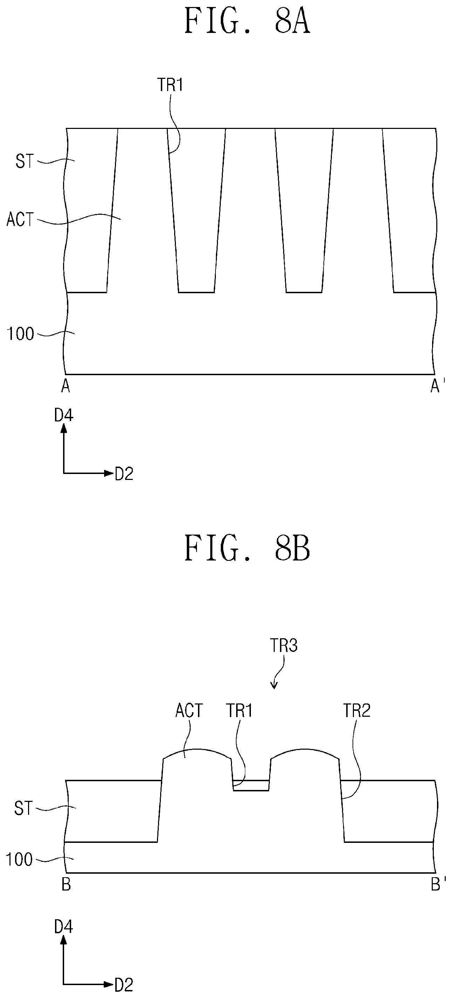

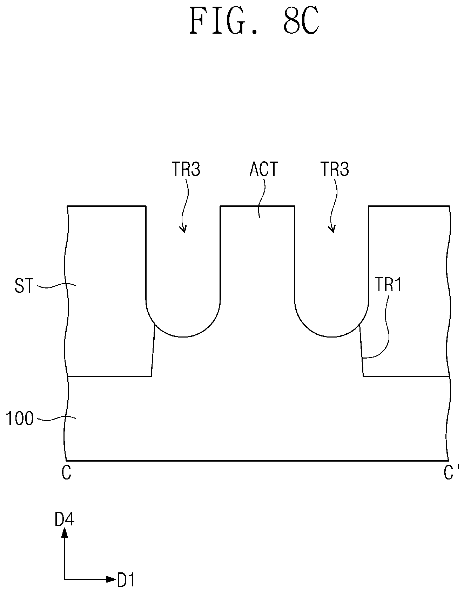

Referring to FIGs. 7 and 8A to 8C, a planarization process may be performed on the device isolation layer ST until the top surfaces of the active patterns ACT are exposed. The active patterns ACT and the device isolation layer ST may be patterned to form third trenches TR3. Each of the third trenches TR3 may have a line shape extending in the second direction D2 when viewed in a plan view.

The third trenches TR3 may be formed by forming a hard mask pattern including openings, and etching the active patterns ACT and the device isolation layer ST, which are exposed through the openings, by using the hard mask pattern as an etch mask. The third trench TR3 may be formed to be shallower than the first trench TR1.

During the etching process, the device isolation layer ST may be etched more than the active patterns ACT (see FIG. 8B). Upper portions of the active patterns ACT in the third trench TR3 may protrude vertically from the device isolation layer ST in the third trench TR3. In other words, the upper portions of the active patterns ACT in the third trench TR3 may have fin shapes.

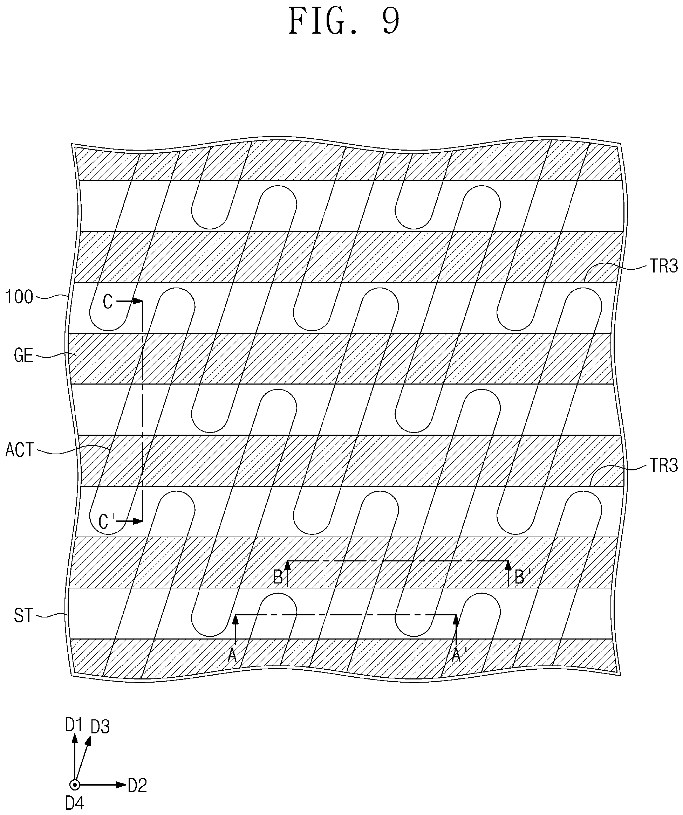

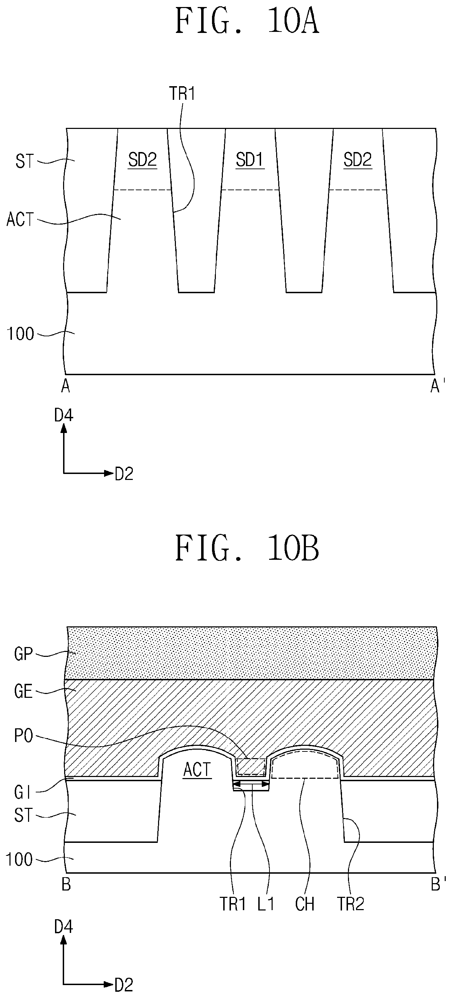

Referring to FIGs. 9 and 10A to 10C, a gate dielectric layer GI, a gate electrode GE and a gate capping layer GP may be formed in each of the third trenches TR3.

In more detail, the gate dielectric layer GI may be conformally formed in each of the third trenches TR3. For example, the gate dielectric layer GI may include a silicon oxide layer, a silicon nitride layer, a silicon oxynitride layer, and/or a high-k dielectric layer. For example, the high-k dielectric layer may include hafnium oxide, hafnium-silicon oxide, lanthanum oxide, zirconium oxide, zirconium-silicon oxide, tantalum oxide, titanium oxide, barium-strontium-titanium oxide, barium-titanium oxide, strontium-titanium oxide, lithium oxide, aluminum oxide, lead-scandium-tantalum oxide, lead-zinc niobate, or any combination thereof.

A conductive layer filling the third trenches TR3 may be formed on the gate dielectric layer GI to form the gate electrodes GE. For example, the conductive layer may include at least one of a conductive metal nitride (e.g., titanium nitride or tantalum nitride) or a metal material (e.g., titanium, tantalum, tungsten, copper, or aluminum).

The gate dielectric layer GI and the gate electrode GE may be recessed, and the gate capping layer GP may be formed on the recessed gate electrode GE. A top surface of the gate capping layer GP may be substantially coplanar with the top surface of the active pattern ACT. The gate capping layer GP may include at least one of a silicon oxide layer, a silicon nitride layer, or a silicon oxynitride layer.

A dopant implantation process may be performed on the active patterns ACT to form a first dopant region SD1 and a pair of second dopant regions SD2 in an upper portion of each of the active patterns ACT where the third trenches TR3 were not formed. The pair of second dopant regions SD2 may be spaced apart from each other in the third direction D2 with the first dopant region SD1 interposed therebetween. The first and second dopant regions SD1 and SD2 may have the same conductivity type (e.g., an N-type).

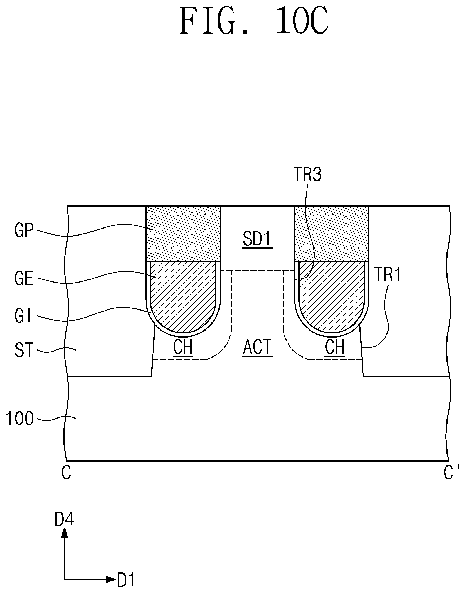

Referring again to FIGs. 10B and 10C, a region of the active pattern ACT under the gate electrode GE may be defined as a channel region CH. The channel region CH may be disposed between the first dopant region SD1 and the second dopant region SD2 when viewed in a plan view. The gate electrode GE may be provided on a top surface and both sidewalls of the channel region CH.

According to the example embodiments, since the semiconductor layer TP is completely oxidized during the formation of the device isolation layer ST described above with reference to FIGs. 5 and 6A to 6C, the distance L1 between two active patterns ACT adjacent to each other in the second direction D2 may be sufficiently secured. Thus, at least a portion PO of the gate electrode GE may be disposed between two channel regions CH adjacent to each other in the second direction D2. Here, at least a lower portion of the two active patterns ACT is completely oxidized to secure a space for the gate electrode GE to be filled in the first trench between these two active patterns ACT. In addition, since the semiconductor layer TP is completely oxidized, it is possible to prevent a defect which may be generated in the active pattern ACT. Thus, it is possible to prevent a leakage current from being generated through a region of the active pattern ACT adjacent to the gate electrode GE. Furthermore, since the semiconductor layer TP on the top surface of the active pattern ACT is selectively oxidized but the active patterns ACT remains without being oxidized, a contact area between the active pattern ACT and a contact CNT may be sufficiently secured.

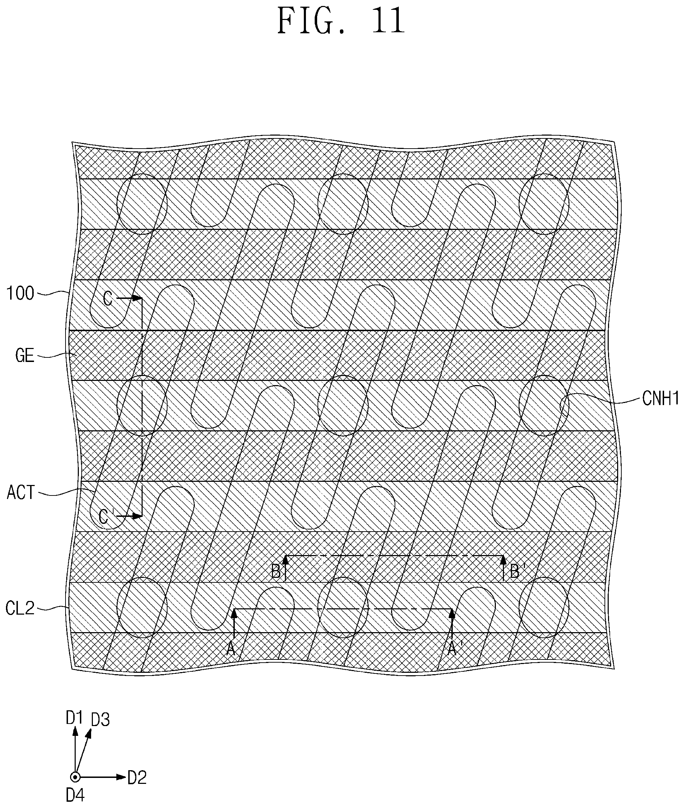

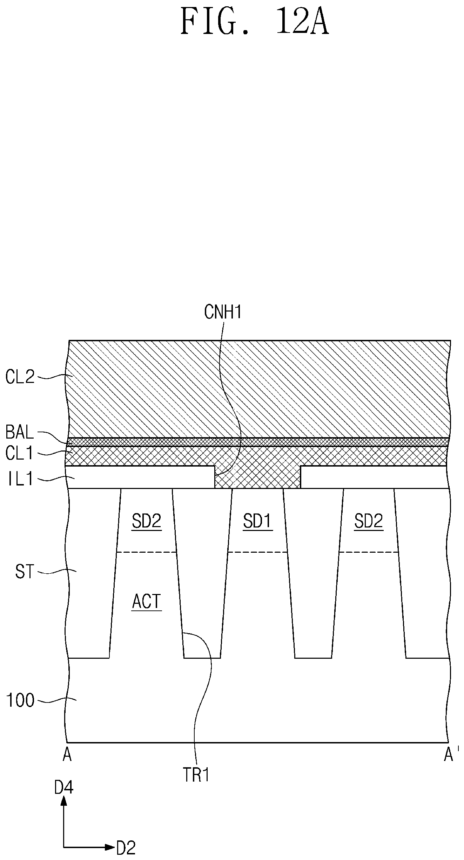

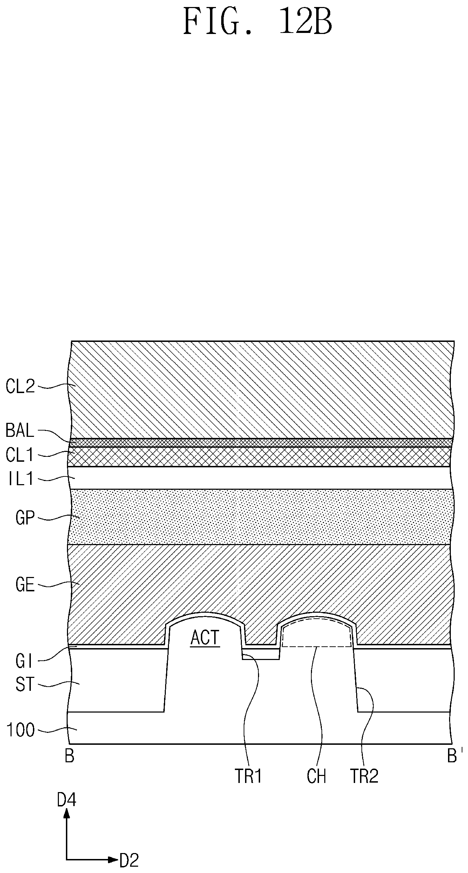

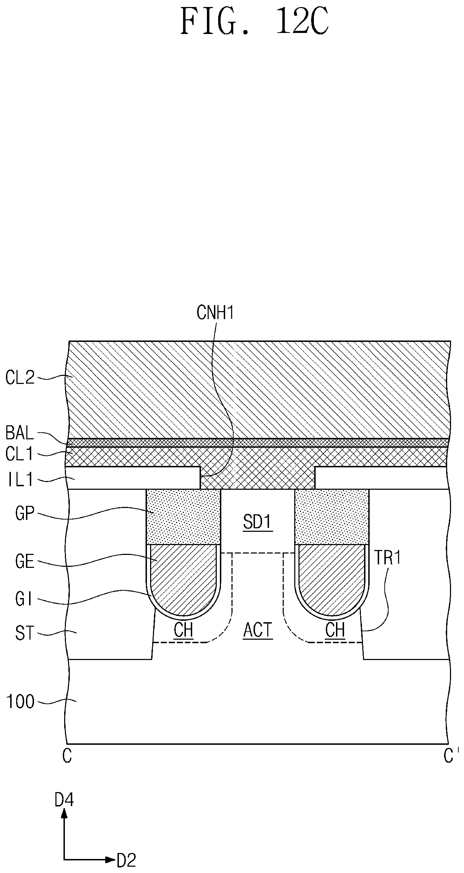

Referring to FIGs. 11 and 12A to 12C, a first interlayer insulating layer IL1 may be formed on an entire surface of the substrate 100. For example, the first interlayer insulating layer IL1 may include a silicon oxide layer. The first interlayer insulating layer IL1 may be patterned to form first contact holes CNH1 exposing the first dopant regions SD1 of the active patterns ACT, respectively.

A first conductive layer CL1, a barrier layer BAL and a second conductive layer CL2 may be sequentially formed on the first interlayer insulating layer IL1. The first conductive layer CL1 may fill the first contact holes CNH1. In other words, the first conductive layer CL1 may be in contact with the first dopant regions SD1 of the active patterns ACT. The first conductive layer CL1 may be vertically spaced apart from the second dopant regions SD2 of the active patterns ACT by the first interlayer insulating layer IL1.

The first conductive layer CL1 may include at least one of a doped semiconductor material (e.g., doped silicon or doped germanium), a metal material (e.g., titanium, tantalum, tungsten, copper, or aluminum), or a metal-semiconductor compound (e.g., tungsten silicide, cobalt silicide, or titanium silicide).

The barrier layer BAL may be disposed between the first conductive layer CL1 and the second conductive layer CL2. For example, the barrier layer BAL may include a conductive metal nitride (e.g., titanium nitride or tantalum nitride). The second conductive layer CL2 may include a metal material (e.g., titanium, tantalum, tungsten, copper, or aluminum). The barrier layer BAL may inhibit or prevent the metal material in the second conductive layer CL2 from being diffused into the first conductive layer CL1.

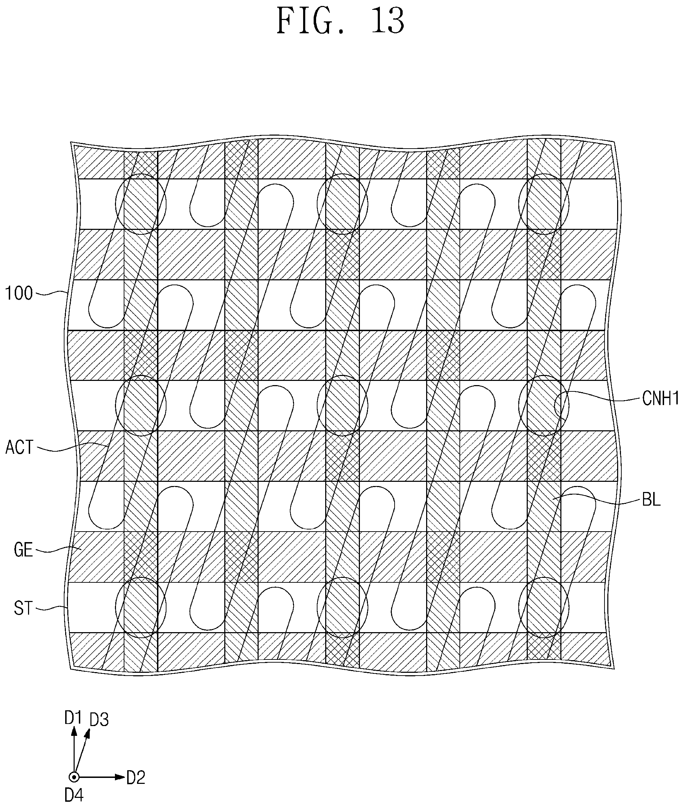

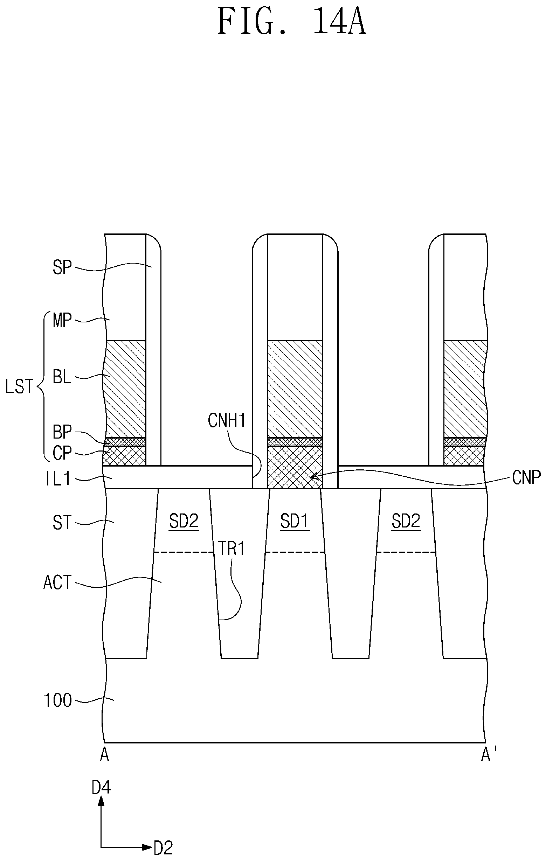

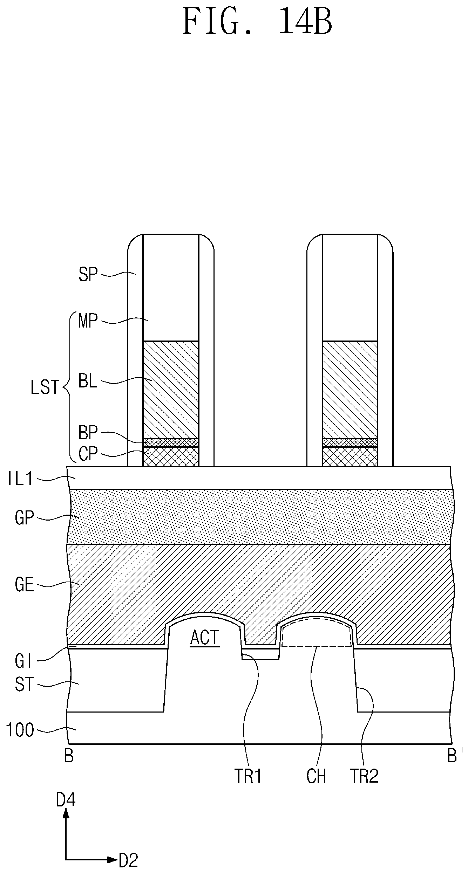

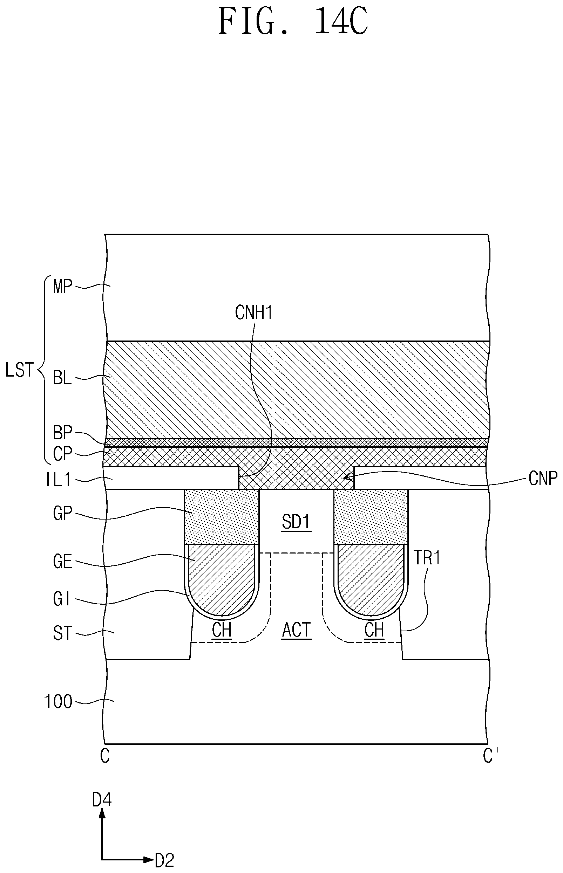

Referring to FIGs. 13 and 14A to 14C, line structures LST extending in a first direction D1 may be formed on the first interlayer insulating layer IL1. The line structures LST may be spaced apart from each other in the second direction D2.

In more detail, mask patterns MP may be formed on the second conductive layer CL2. The mask patterns MP may have line shapes extending in the first direction D1. For example, the mask patterns MP may include a silicon nitride layer or a silicon oxynitride layer.

The second conductive layer CL2, the barrier layer BAL and the first conductive layer CL1 may be sequentially etched using the mask patterns MP as etch masks to form a bit line BL, a barrier pattern BP and a conductive pattern CP under each of the mask patterns MP. The mask pattern MP, the bit line BL, the barrier pattern BP and the conductive pattern CP may vertically overlap with each other. The mask pattern MP, the bit line BL, the barrier pattern BP and the conductive pattern CP may constitute the line structure LST. The bit lines BL may extend to intersect the gate electrodes GE, when viewed in a plan view.

The conductive pattern CP may include contact portions CNP filling the first contact holes CNH1, respectively. The conductive pattern CP may be connected to the first dopant region SD1 through the contact portion CNP. In other words, the bit line BL may be electrically connected to the first dopant region SD1 through the conductive pattern CP.

A pair of spacers SP may be formed on both sidewalls of each of the line structures LST. The formation of the spacers SP may include conformally forming a spacer layer on the substrate 100 and anisotropically etching the spacer layer. The spacer layer may include at least one of a silicon oxide layer, a silicon nitride layer, or a silicon oxynitride layer.

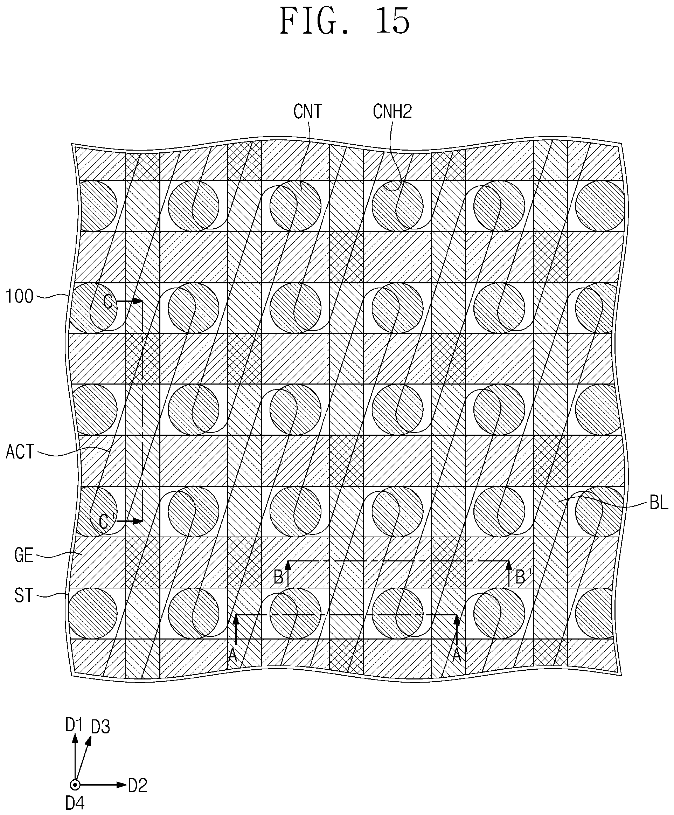

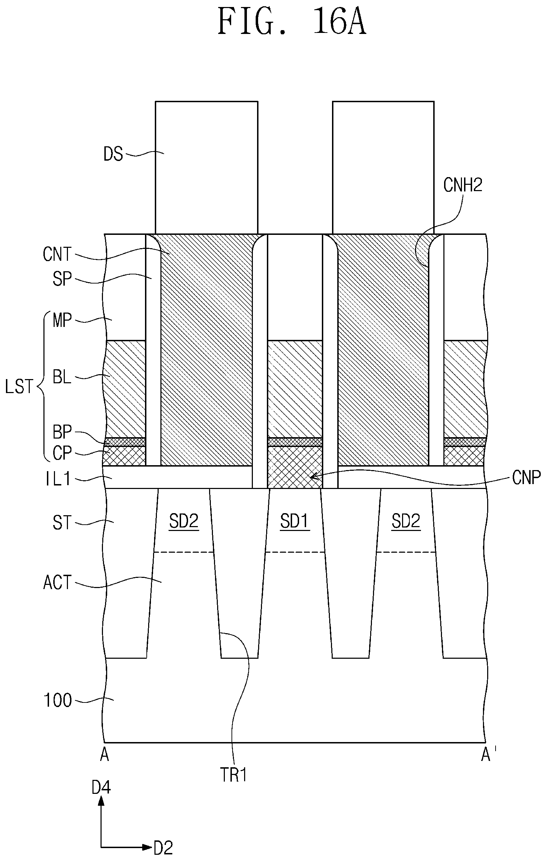

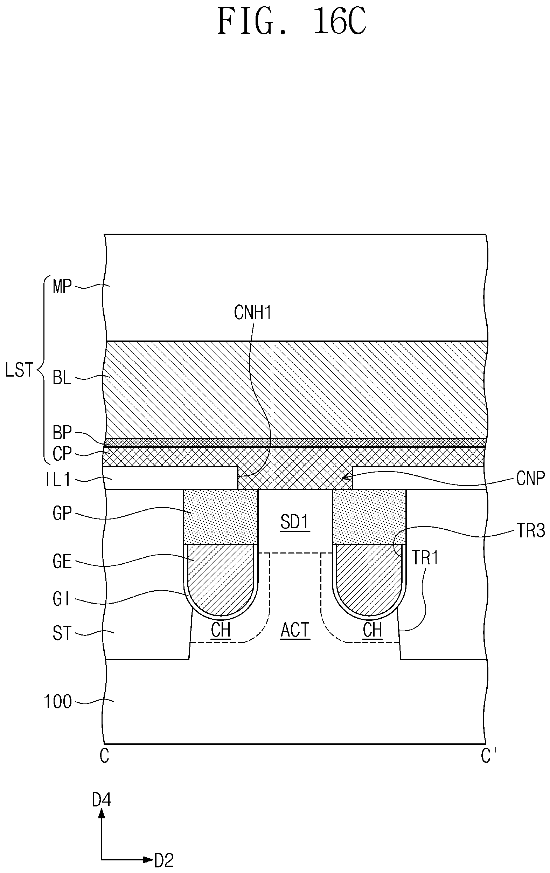

Referring to FIGs. 15 and 16A to 16C, a second interlayer insulating layer IL2 may be formed on the substrate 100. For example, the second interlayer insulating layer IL2 may include a silicon oxide layer. A planarization process may be performed on the second interlayer insulating layer IL2 until top surfaces of the mask patterns MP are exposed.

The second interlayer insulating layer IL2 and the first interlayer insulating layer IL1 may be patterned to form second contact holes CNH2 exposing the second dopant regions SD2 of the active patterns ACT, respectively. The mask patterns MP and the spacers SP may be used as etch masks during the patterning process, and thus the second contact holes CNH2 may be formed to be self-aligned with the mask patterns MP and the spacers SP.

Contacts CNT may be formed by filling the second contact holes CNH2 with a conductive material. For example, the conductive material may include at least one of a conductive metal nitride (e.g., titanium nitride or tantalum nitride) or a metal material (e.g., titanium, tantalum, tungsten, copper, or aluminum). The contacts CNT may be connected to the second dopant regions SD2, respectively. The contacts CNT may be spaced apart from the bit lines BL by the spacers SP.

Data storage elements DS may be formed on the contacts CNT, respectively. For example, each of the data storage elements DS may be a memory element using a capacitor, a memory element using a magnetic tunnel junction (MTJ) pattern, or a memory element using a variable resistor including a phase-change material. In example embodiments, each of the data storage elements DS may be a capacitor.

A semiconductor device according to example embodiments of the inventive concepts will be described with reference to FIGs. 15 and 16A to 16C. The device isolation layer ST may be provided in an upper portion of the substrate 100 to define the active patterns ACT. Each of the active patterns ACT may extend in the third direction D3. Some of the active patterns ACT may be spaced apart from each other in the third direction D3. The active patterns ACT may be two-dimensionally arranged.

The device isolation layer ST may fill the first and second trenches TR1 and TR2 between the active patterns ACT. The first trench TR1 may be defined between two active patterns ACT adjacent to each other in the second direction D2. The second trench TR2 may be defined between two active patterns ACT adjacent to each other in the third direction D3. The second trench TR2 may be deeper than the first trench TR1.

Each of the active patterns ACT may include the first dopant region SD1 and the pair of second dopant regions SD2. The first dopant region SD1 may be located between the pair of second dopant regions SD2. The first and second dopant regions SD1 and SD2 may have the same conductivity type (e.g., an N-type).

A pair of the third trenches TR3 may be defined in an upper portion of each of the active patterns ACT. Each of the third trenches TR3 may be defined between the first dopant region SD1 and the second dopant region SD2. The third trench TR3 may extend downward from the top surface of the active pattern ACT toward the bottom surface of the substrate 100. A bottom of the third trench TR3 may be higher than the bottoms of the first and second trenches TR1 and TR2.

Each of the active patterns ACT may also include a pair of the channel regions CH. The channel region CH may be disposed between the first dopant region SD1 and the second dopant region SD2 when viewed in a plan view. The channel region CH may be located under the third trench TR3. Thus, the channel region CH may be lower than the first and second dopant regions SD1 and SD2.

The gate electrodes GE may be provided to intersect the active patterns ACT and the device isolation layer ST. The gate electrodes GE may be provided in the third trenches TR3. The gate electrodes GE may extend in the second direction D2 in parallel to each other. A pair of the gate electrodes GE may be respectively provided on the pair of channel regions CH of each of the active patterns ACT. Top surfaces of the gate electrodes GE may be lower than the top surfaces of the active patterns ACT (e.g., top surfaces of the first dopant regions SD1 or top surfaces of the second dopant regions SD2).

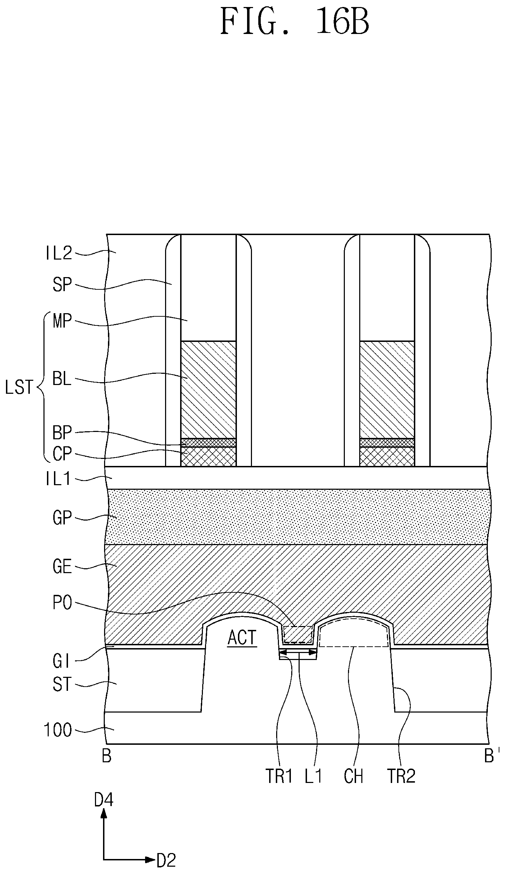

Referring again to FIG. 16B, the channel region CH under the gate electrode GE may protrude vertically from the device isolation layer ST under the gate electrode GE. In other words, the channel region CH under the gate electrode GE may be located at a higher level than a top surface of the device isolation layer ST under the gate electrode GE. The channel region CH under the gate electrode GE may have a fin shape. A first bottom surface of the gate electrode GE above the device isolation layer ST may be lower than a second bottom surface of the gate electrode GE above the channel region CH.

At least a portion PO of the gate electrode GE may be disposed between a pair of the channel regions CH adjacent to each other in the second direction D2. The portion PO of the gate electrode GE may be disposed on the device isolation layer ST in the first trench TR1.

According to example embodiments, the distance L1 between the pair of active patterns ACT adjacent to each other in the second direction D2 may be secured such that the portion PO of the gate electrode GE is disposed between the pair of active patterns ACT. Thus, the gate electrode GE may surround the top surface and the both sidewalls of the channel region CH to improve electrical characteristics of a transistor including the gate electrode GE.

Referring again to FIGs. 15 and 16A to 16C, the gate dielectric layer GI may be disposed between the gate electrode GE and the active pattern ACT. The gate capping layer GP may be provided on the gate electrode GE. The gate capping layer GP may cover the top surface of the gate electrode GE. The top surface of the gate capping layer GP may be substantially coplanar with the top surface of the active pattern ACT.

The first interlayer insulating layer IL1 may be provided on the substrate 100. The first interlayer insulating layer IL1 may include the first contact holes CNH1 exposing the first dopant regions SD1 of the active patterns ACT.

The line structures LST extending in the first direction D1 may be provided on the first interlayer insulating layer IL1. The line structures LST may be spaced apart from each other in the second direction D2. The line structures LST may intersect the gate electrodes GE when viewed in a plan view. The pair of spacers SP may be provided on the both sidewalls of each of the line structures LST.

Each of the line structures LST may include the conductive pattern CP, the barrier pattern BP, the bit line BL and the mask pattern MP, which are sequentially stacked. The conductive pattern CP may include the contact portion CNP which fills the first contact hole CNH1 and is in contact with the first dopant region SD1. The bit line BL may be electrically connected to the first dopant region SD1 through the barrier pattern BP and the conductive pattern CP.

The second interlayer insulating layer IL2 may be provided on the first interlayer insulating layer IL1. The second interlayer insulating layer IL2 may cover the spacers SP. The contacts CNT may penetrate the second interlayer insulating layer IL2 and the first interlayer insulating layer IL1 so as to be connected to the second dopant regions SD2, respectively. The contacts CNT may be spaced apart from the bit lines BL by the spacers SP. The data storage elements DS may be provided on the contacts CNT, respectively. In example embodiments, each of the data storage elements DS may be the capacitor.

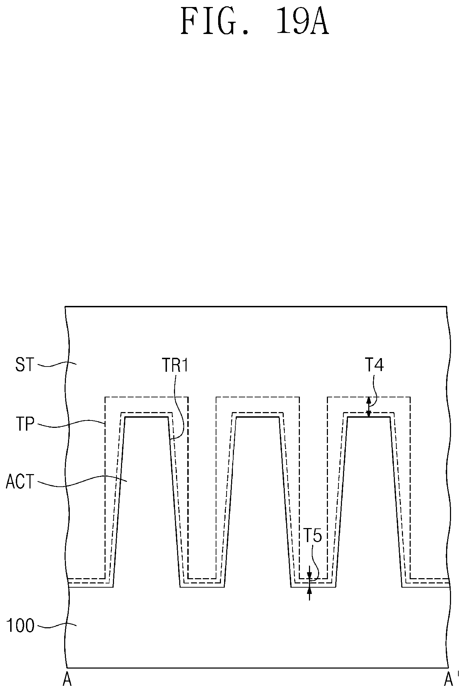

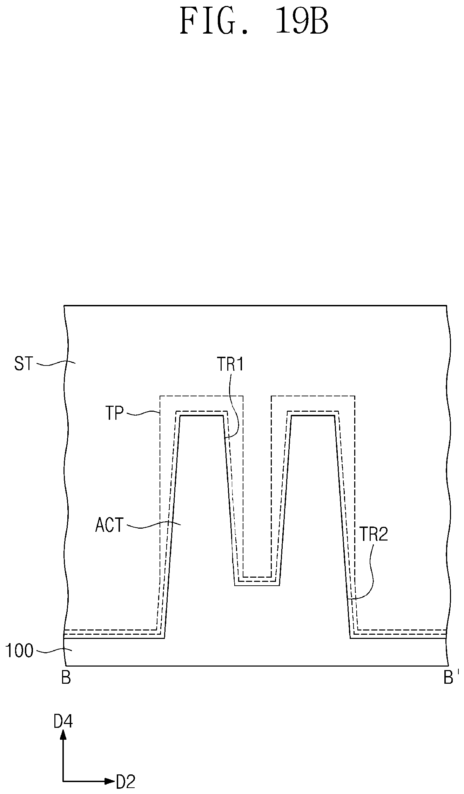

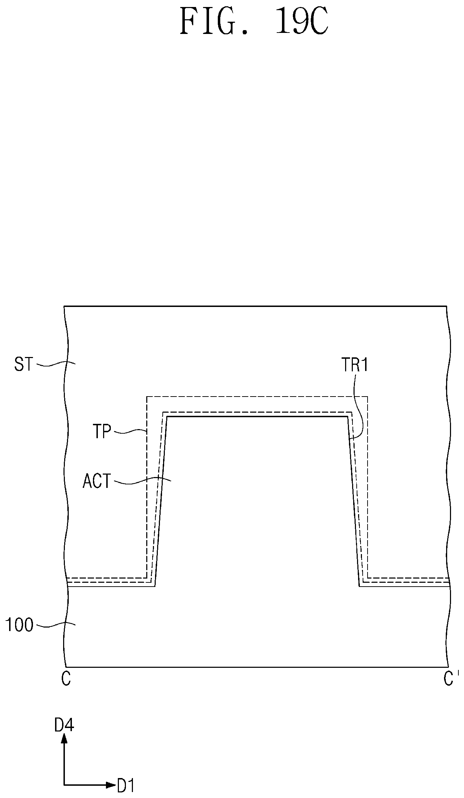

FIGs. 19A, 19B and 19C are cross-sectional views taken along the lines A-A', B-B' and C-C' of FIG. 5, respectively, to illustrate a method for manufacturing a semiconductor device according to example embodiments. In the present embodiments, the descriptions to the same technical features as in the above embodiments of FIGs. 1 to 16C will be omitted or mentioned briefly for the purpose of ease and convenience in explanation. In other words, differences between the present embodiments and the above embodiments of FIGs. 1 to 16C will be mainly described hereinafter.

Referring to FIGs. 5 and 19A to 19C, a device isolation layer ST may be formed on the resultant structure of FIGs. 3 and 4A to 4C. The device isolation layer ST may be formed by performing a semiconductor oxidation process. The semiconductor layer TP may be completely oxidized in the semiconductor oxidation process. A portion of the active pattern ACT may be additionally oxidized after the complete oxidation of the semiconductor layer TP in the semiconductor oxidation process.

For example, during the semiconductor oxidation process, a semiconductor material may be reduced by a fourth thickness T4 from a top surface of the semiconductor layer TP disposed on the top surface of the active pattern ACT. During the semiconductor oxidation process, a semiconductor material may be reduced by a fifth thickness T5 from a top surface of the semiconductor layer TP disposed on the bottom of the first trench TR1. The fourth thickness T4 may be greater than the first thickness T1 of the semiconductor layer TP of FIGs. 3 and 4A to 4C. The fifth thickness T5 may be greater than the second thickness T2 of the semiconductor layer TP of FIGs. 3 and 4A to 4C.

As a result, a size of each of the active patterns ACT after the semiconductor oxidation process may be smaller than a size of each of the active patterns ACT of FIGs. 1 and 2A to 2C. Subsequent processes may be substantially the same as described above with reference to FIGs. 7 to 16C.

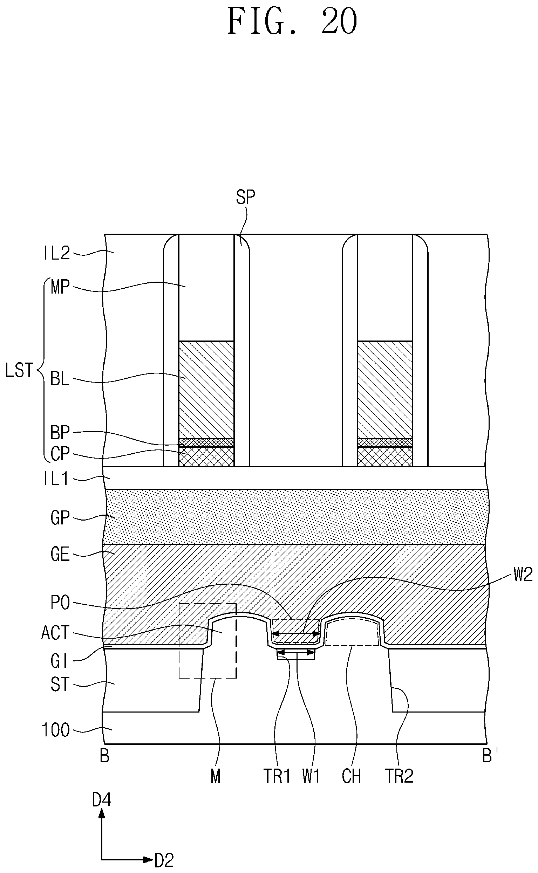

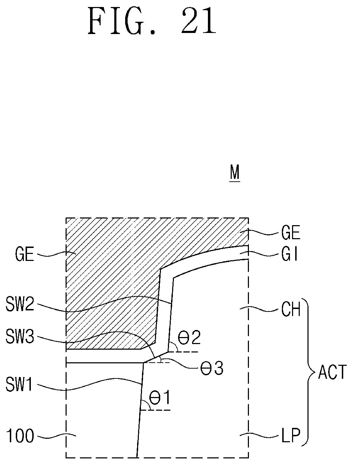

FIG. 20 is a cross-sectional view taken along the line B-B' of FIG. 15 to illustrate a semiconductor device according to example embodiments. FIG. 21 is an enlarged cross-sectional view of a region 'M' of FIG. 20. In the present embodiments, the descriptions to the same technical features as in the embodiments of FIGs. 15 and 16A to 16C will be omitted for the purpose of ease and convenience in explanation. In other words, differences between the present embodiments and the embodiments of FIGs. 15 and 16A to 16C will be mainly described hereinafter.

Referring to FIGs. 15, 16A, 16C, 20 and 21, a lower portion LP of an active pattern ACT may have a first sidewall SW1 covered or surrounded by the device isolation layer ST. A channel region CH of the active pattern ACT may have a second sidewall SW2 covered or surrounded by the gate dielectric layer GI and the gate electrode GE. The active pattern ACT may further have a third sidewall SW3 connecting the first sidewall SW1 and the second sidewall SW2. The third sidewall SW3 may be gentler than the first sidewall SW1 and may be gentler than the second sidewall SW2.

In more detail, the first sidewall SW1 may make a first angle θ1 with the bottom surface of the substrate 100, the second sidewall SW2 may make a second angle θ2 with the bottom surface of the substrate 100, and the third sidewall SW3 may make a third angle θ3 with the bottom surface of the substrate 100. Here, the first angle θ1 may be greater than the third angle θ3, and the second angle θ2 may be greater than the third angle θ3.

As a result, a width of the active pattern ACT in the second direction D2 may be significantly reduced from the lower portion LP of the active pattern ACT toward the channel region CH of the active pattern ACT.

The device isolation layer ST filling the first trench TR1 under the gate electrode GE may have a first width W1 in the second direction D2. The portion PO of the gate electrode GE, which is disposed between a pair of the channel regions CH adjacent to each other in the second direction D2, may have a second width W2 in the second direction D2. The second width W2 may be greater than the first width W1.

According to the example embodiments, the width of the channel region CH may be greatly reduced compared to the width of the lower portion LP of the active pattern ACT, and thus the portion PO of the gate electrode GE may be easily formed between the pair of channel regions CH adjacent to each other. As a result, the gate electrode GE may surround the top surface and the both sidewalls of the channel region CH to improve electrical characteristics of a transistor including the gate electrode GE.

According to example embodiments, at least a portion of the gate electrode may be formed to be disposed between the channel regions of the active patterns adjacent to each other. Thus, it is possible to prevent a leakage current from being generated through a region of the active pattern adjacent to the gate electrode. Furthermore, a contact area between the active pattern ACT and the contact CNT may be sufficiently secured.

While the inventive concepts have been described with reference to example embodiments, it will be apparent to those skilled in the art that various changes and modifications may be made Therefore, it should be understood that the above embodiments are not limiting, but illustrative, the scope of protection sought being defined solely by the appended claims.

## Claims

1. A method of manufacturing a semiconductor device, the method comprising:
patterning a semiconductor substrate (100) to form a plurality of active patterns (ACT) comprising two active patterns (ACT) arranged in a first direction (D1) to be adjacent to each other and having a first trench (TR1) therebetween;
forming a semiconductor layer (TP) on the plurality of active patterns (ACT) so that the semiconductor layer (TP) covers the plurality of active patterns (ACT);
forming a device isolation layer (ST) on the semiconductor layer (TP) so that the device isolation layer (ST) covers the semiconductor layer (TP), fills the first trench (TR1) covered by the semiconductor layer (TP), and the semiconductor layer (TP) is oxidized;
patterning the device isolation layer (ST) and the plurality of active patterns (ACT) so that a second trench (TR3) intersecting the first trench (TR1) is formed and the two active patterns (ACT) protrude from the device isolation layer (ST) in the second trench (TR3); and
forming a gate electrode (GE) in the second trench (TR3),
wherein the forming the semiconductor layer (ST) on the plurality of active patterns (ACT) is performed such that a first thickness (T1) of the semiconductor layer (TP) covering a top surface of each of the two active patterns (ACT) is greater than a second thickness (T2) of the semiconductor layer (TP) covering a bottom of the first trench (TR1),
wherein the semiconductor layer (TP) is formed to cover a surface of each of the plurality of active patterns (ACT), and
wherein forming the device isolation layer includes a semiconductor oxidation process during which the semiconductor layer (TP) is oxidized, so that the semiconductor layer (TP) prevents the plurality of active patterns (ACT) from being oxidized,
wherein, by the patterning the semiconductor substrate (100), a third trench (TR2) is formed between two active patterns (ACT) adjacent to each other and arranged in a second direction (D2) oblique to the first direction (D1), and
wherein the third trench (TR2) is deeper than the first trench (TR1),
wherein the forming the semiconductor layer (TP) on the plurality of active patterns (ACT) comprises:
inserting the semiconductor substrate (100) in a single-type reaction chamber (CHA), and depositing the semiconductor substrate (100) on a susceptor (SUS);
heating the semiconductor substrate (100) on the susceptor (SUS) ; and
performing a chemical vapor deposition, CVD, process by injecting a source gas into the single-type reaction chamber (CHA) and exhausting the injected source gas from the single-type reaction chamber (CHA),
wherein the CVD process is performed at a pressure of 10 Torr to 200 Torr, a temperature of 400°C to 600°C, and a flow rate of the source gas ranges from 5 sccm to 50 sccm,
wherein a ratio of the first thickness (T1) to the second thickness (T2) is set between 0.5 and 0.85.

2. The method of claim 1, wherein the source gas comprises SiₓH₂ₓ₊₂, SiCl₄, SiCl₆, or SiCl₂H₄, 'x' being an integer equal to or greater than 1.

3. The method of claim 2, wherein the source gas comprises monosilane or disilane.

4. The method of claim 1, wherein hydrogen is injected together with the source gas in the single-type reaction chamber (CHA) in the performing the CVD process.

5. The method of claim 1, wherein the performing the CVD process further comprises injecting another source gas comprising aminosilane into the single-type reaction chamber (CHA) to form a semiconductor nitride layer on the plurality of active patterns (ACT), prior to the injecting the source gas into the single-type reaction chamber (CHA).

6. A method of claim 1, comprising
forming the semiconductor layer (TP) on the plurality of active patterns (ACT) to cover the plurality of active patterns (ACT) such that a thickness of the semiconductor layer (TP) along an outer surface of each of the two active patterns (ACT) diminishes in a downward direction from a top portion toward a bottom portion of each of the two active patterns (ACT);
wherein, after the oxidizing the at least the semiconductor layer (TP), all of the semiconductor layer (TP) is oxidized at least at a lower part of each of the two active patterns (ACT) so that a space for a portion of the gate electrode (GE) to be filled between the two active patterns (ACT) is provided in the first trench (TR1) after the patterning the device isolation layer (ST) and the plurality of active patterns (ACT).

7. The method of claim 6, wherein, after the oxidizing the at least the semiconductor layer (TP), at least a portion of each of the plurality of active patterns (ACT) is oxidized.

## Patentansprüche

1. Ein Verfahren zur Herstellung einer Halbleitervorrichtung, wobei das Verfahren umfasst:
Strukturieren eines Halbleitersubstrats (100), um eine Mehrzahl von aktiven Mustern (ACT) zu bilden, die zwei aktive Muster (ACT) umfassen, die in einer ersten Richtung (D1) nebeneinander angeordnet sind und zwischen denen sich ein erster Graben (TR1) befindet;
Bilden einer Halbleiterschicht (TP) auf der Mehrzahl von aktiven Mustern (ACT), so dass die Halbleiterschicht (TP) die Mehrzahl von aktiven Mustern (ACT) bedeckt;
Bilden einer Vorrichtungsisolierschicht (ST) auf der Halbleiterschicht (TP), so dass die Vorrichtungsisolierschicht (ST) die Halbleiterschicht (TP) bedeckt, den von der Halbleiterschicht (TP) bedeckten ersten Graben (TR1) ausfüllt und die Halbleiterschicht (TP) oxidiert wird;
Strukturieren der Vorrichtungsisolierschicht (ST) und der Mehrzahl von aktiven Mustern (ACT), so dass ein zweiter Graben (TR3), der den ersten Graben (TR1) schneidet, gebildet wird und die beiden aktiven Muster (ACT) aus der Vorrichtungsisolierschicht (ST) in den zweiten Graben (TR3) hineinragen; und
Bilden einer Gate-Elektrode (GE) in dem zweiten Graben (TR3),
wobei das Ausbilden der Halbleiterschicht (ST) auf der Mehrzahl von aktiven Mustern (ACT) derart durchgeführt wird, dass eine erste Dicke (T1) der Halbleiterschicht (TP), die eine Oberseite jedes der beiden aktiven Muster (ACT) bedeckt, größer ist als eine zweite Dicke (T2) der Halbleiterschicht (TP), die einen Boden des ersten Grabens (TR1) bedeckt,
wobei die Halbleiterschicht (TP) derart gebildet wird, dass sie eine Oberfläche jedes der Mehrzahl von aktiven Mustern (ACT) bedeckt, und
wobei das Bilden der Vorrichtungsisolierschicht einen Halbleiteroxidationsprozess umfasst, während dessen die Halbleiterschicht (TP) oxidiert wird, so dass die Halbleiterschicht (TP) verhindert, dass die Mehrzahl von aktiven Mustern (ACT) oxidiert wird,
wobei durch das Strukturieren des Halbleitersubstrats (100) ein dritter Graben (TR2) zwischen zwei aktiven Mustern (ACT) gebildet wird, die nebeneinander liegen und in einer zweiten Richtung (D2) schräg zur ersten Richtung (D1) angeordnet sind, und
wobei der dritte Graben (TR2) tiefer ist als der erste Graben (TR1),
wobei das Bilden der Halbleiterschicht (TP) auf der Mehrzahl von aktiven Mustern (ACT) umfasst:
Einbringen des Halbleitersubstrats (100) in eine Reaktionskammer vom Einzeltyp (CHA) und Abscheiden des Halbleitersubstrats (100) auf einem Suszeptor (SUS);
Erwärmen des Halbleitersubstrats (100) auf dem Suszeptor (SUS); und
Durchführen eines chemischen Gasphasenabscheidungsprozesses, CVD, durch Einleiten eines Ausgangsgases in die Reaktionskammer vom Einzeltyp (CHA) und Abführen des eingeleiteten Ausgangsgases aus der Reaktionskammer vom Einzeltyp (CHA),
wobei der CVD-Prozess bei einem Druck von 10 Torr bis 200 Torr, bei einer Temperatur von 400 °C bis 600 °C und einer Durchflussrate des Ausgangsgases im Bereich von 5 sccm bis 50 sccm durchgeführt wird,
wobei ein Verhältnis der ersten Dicke (T1) zur zweiten Dicke (T2) zwischen 0,5 und 0,85 eingestellt wird.

2. Das Verfahren nach Anspruch 1, wobei das Ausgangsgas SiₓH₂ₓ+₂, SiCl₄, SiCl₆, oder SiCl₂H₄ umfasst, wobei "x" eine ganze Zahl von 1 oder mehr ist.

3. Das Verfahren nach Anspruch 2, wobei das Ausgangsgas Monosilan oder Disilan umfasst.

4. Das Verfahren nach Anspruch 1, wobei bei der Durchführung des CVD-Prozesses Wasserstoff zusammen mit dem Ausgangsgas in die Reaktionskammer vom Einzeltyp (CHA) eingeleitet wird.

5. Das Verfahren nach Anspruch 1, wobei das Durchführen des CVD-Prozesses ferner das Einleiten eines weiteren Ausgangsgases, das Aminosilan enthält, in die Reaktionskammer vom Einzeltyp (CHA) umfasst, um eine Halbleiternitridschicht auf der Mehrzahl von aktiven Mustern (ACT) zu bilden, bevor das Ausgangsgas in die Reaktionskammer vom Einzeltyp (CHA) eingeleitet wird.

6. Das Verfahren nach Anspruch 1, umfassend
das Ausbilden der Halbleiterschicht (TP) auf der Mehrzahl von aktiven Mustern (ACT), um die Mehrzahl von aktiven Mustern (ACT) derart zu bedecken, dass sich die Dicke der Halbleiterschicht (TP) entlang einer Außenfläche jedes der beiden aktiven Muster (ACT) in Abwärtsrichtung von einem oberen Abschnitt zu einem unteren Abschnitt jedes der beiden aktiven Muster (ACT) verringert;
wobei nach dem Oxidieren zumindest der Halbleiterschicht (TP) die gesamte Halbleiterschicht (TP) zumindest an einem unteren Teil jedes der beiden aktiven Muster (ACT) oxidiert wird, so dass in dem ersten Graben (TR1) nach dem Strukturieren der Vorrichtungsisolierschicht (ST) und der Mehrzahl von aktiven Mustern (ACT) ein Raum für einen Teil der Gate-Elektrode (GE) bereitgestellt wird, der zwischen den beiden aktiven Mustern (ACT) ausgefüllt werden soll.

7. Das Verfahren nach Anspruch 6, wobei nach dem Oxidieren zumindest der Halbleiterschicht (TP) zumindest ein Abschnitt jedes der Mehrzahl von aktiven Mustern (ACT) oxidiert wird.

## Revendications

1. Un procédé de fabrication d'un dispositif à semi-conducteur, le procédé comprenant :
structurer un substrat semi-conducteur (100) pour former une pluralité de motifs actifs (ACT) comprenant deux motifs actifs (ACT) disposés dans une première direction (D1) de manière à être adjacents l'un à l'autre et séparés par une première tranchée (TR1) ;
former une couche semi-conductrice (TP) sur la pluralité de motifs actifs (ACT) de telle sorte que la couche semi-conductrice (TP) recouvre la pluralité de motifs actifs (ACT) ;
former une couche d'isolation de dispositif (ST) sur la couche semi-conductrice (TP) de telle sorte que la couche d'isolation de dispositif (ST) recouvre la couche semi-conductrice (TP), remplisse la première tranchée (TR1) recouverte par la couche semi-conductrice (TP), et que la couche semi-conductrice (TP) soit oxydée ;
structurer la couche d'isolation de dispositif (ST) et de la pluralité de motifs actifs (ACT) de telle sorte qu'une deuxième tranchée (TR3) coupant la première tranchée (TR1) soit formée et que les deux motifs actifs (ACT) dépassent de la couche d'isolation de dispositif (ST) dans la deuxième tranchée (TR3) ; et
former une électrode de grille (GE) dans la deuxième tranchée (TR3),
dans lequel la formation de la couche semi-conductrice (ST) sur la pluralité de motifs actifs (ACT) est effectuée de telle sorte qu'une première épaisseur (T1) de la couche semi-conductrice (TP) recouvrant une surface supérieure de chacun des deux motifs actifs (ACT) soit supérieure à une deuxième épaisseur (T2) de la couche semi-conductrice (TP) recouvrant un fond de la première tranchée (TR1),
dans lequel la couche semi-conductrice (TP) est formée de manière à recouvrir une surface de chacun de la pluralité de motifs actifs (ACT), et
dans lequel la formation de la couche d'isolation du dispositif comprend un processus d'oxydation du semi-conducteur au cours duquel la couche semi-conductrice (TP) est oxydée, de sorte que la couche semi-conductrice (TP) empêche la pluralité de motifs actifs (ACT) d'être oxydés,
dans lequel, par la structuration du substrat semi-conducteur (100), une troisième tranchée (TR2) est formée entre deux motifs actifs (ACT) adjacents l'un à l'autre et disposés dans une deuxième direction (D2) oblique par rapport à la première direction (D1), et
dans lequel la troisième tranchée (TR2) est plus profonde que la première tranchée (TR1),
dans lequel la formation de la couche semi-conductrice (TP) sur la pluralité de motifs actifs (ACT) comprend :
insérer le substrat semi-conducteur (100) dans une chambre de réaction de type unique (CHA), et le dépôt du substrat semi-conducteur (100) sur un suscepteur (SUS) ;
chauffer le substrat semi-conducteur (100) sur le suscepteur (SUS) ; et
mettre en œuvre d'un procédé de dépôt chimique en phase vapeur, CVD, par injection d'un gaz source dans la chambre de réaction de type unique (CHA) et l'évacuation du gaz source injecté hors de la chambre de réaction de type unique (CHA),
dans lequel le procédé CVD est mis en œuvre à une pression comprise entre 10 Torr et 200 Torr, à une température comprise entre 400 °C et 600 °C, et le débit du gaz source est compris entre 5 sccm et 50 sccm,
dans lequel le rapport entre la première épaisseur (T1) et la deuxième épaisseur (T2) est fixé entre 0,5 et 0,85.

2. Le procédé selon la revendication 1, dans lequel le gaz source comprend du SiₓH₂ₓ₊₂, du SiCl₄, du SiCl₆, ou du SiCl₂H₄, « x » étant un nombre entier égal ou supérieur à 1.

3. Le procédé selon la revendication 2, dans lequel le gaz source comprend du monosilane ou du disilane.

4. Le procédé selon la revendication 1, dans lequel de l'hydrogène est injecté conjointement avec le gaz source dans la chambre de réaction de type unique (CHA) lors de la mise en œuvre du procédé CVD.

5. Le procédé selon la revendication 1, dans lequel la mise en œuvre du procédé CVD comprend en outre l'injection d'un autre gaz source comprenant de l'aminosilane dans la chambre de réaction de type unique (CHA) afin de former une couche de nitrure semi-conducteur sur la pluralité de motifs actifs (ACT), avant l'injection du gaz source dans la chambre de réaction de type unique (CHA).

6. Le procédé selon la revendication 1, comprenant
former la couche semi-conductrice (TP) sur la pluralité de motifs actifs (ACT) de manière à recouvrir ladite pluralité de motifs actifs (ACT), de telle sorte que l'épaisseur de la couche semi-conductrice (TP) le long d'une surface extérieure de chacun des deux motifs actifs (ACT) diminue vers le bas, depuis une partie supérieure vers une partie inférieure de chacun des deux motifs actifs (ACT) ;
dans lequel, après l'oxydation d'au moins la couche semi-conductrice (TP), la totalité de la couche semi-conductrice (TP) est oxydée au moins au niveau d'une partie inférieure de chacun des deux motifs actifs (ACT) de sorte qu'un espace destiné à être rempli par une partie de l'électrode de grille (GE) entre les deux motifs actifs (ACT) est prévu dans la première tranchée (TR1) après la formation de la couche d'isolation du dispositif (ST) et de la pluralité de motifs actifs (ACT).

7. Le procédé selon la revendication 6, dans lequel, après l'oxydation d'au moins la couche semi-conductrice (TP), au moins une partie de chacun des motifs actifs (ACT) est oxydée.
